# EUROPEAN PATENT APPLICATION

(11) **EP 2 924 481 A1**
(43) Date of publication of application: **30.09.2015**
(21) Application number: 14305440.1
(22) Date of filing: 26.03.2014
(51) Int. Cl.: G02B 6/12, G02B 6/293

(54) **Monolithically integrated photonic tunable receiver for selecting optical signals with different wavelengths**

(71) Applicant: ALCATEL LUCENT, 92100 Boulogne-Billancourt (FR); Commissariat à l'Énergie Atomique et aux Énergies Alternatives, 75015 Paris (FR)
(72) Inventor: Achouche, Mohand, 91460 MARCOUSSIS (FR)
(74) Representative: Novagraaf Technologies

(57) **Abstract**

A photonic tunable receiver (1) is intended for receiving input optical signals with at least two different wavelengths transmitted by an optical fibre. This photonic tunable receiver (1) comprises i) a photonic chip (2) defining a waveguide (3), ii) a gain chip region (4) bonded to this photonic chip (2) and arranged for amplifying the input optical signals, iii) a tunable filter (5), at least partially integrated into the photonic chip (2), and arranged for selecting a signal having a desired wavelength amongst the amplified input optical signals, and iv) a high speed photodetector (6) bound to the photonic chip (2) and arranged for detecting the selected signal.

## Description

### Field of the Invention

The present invention relates to optical fibre access networks and more precisely to tunable amplified receivers that are used in such networks for receiving optical signals with different wavelengths.

### Background

Increasing the number of wavelengths simultaneously transmitted by an optical fibre is a solution for increasing bandwidth in optical fibre access networks. But such an increase requires that tunable receivers be able to select the different incoming channel signals with different wavelengths. So, dynamic wavelength allocation capability in a cost-effective manner, while improving energy efficiency, is widely investigated.

Most of the existing solutions to built a tunable receiver are based on large size bulk optics and Fabry Perot thin film filters associated with a III-V semiconductor photodetector (generally an APD ("Amplifier PhotoDetector") to improve signal to noise ratio and to ensure high wavelength splitting ratio).

For instance, a tunable receiver component comprising a tunable thin-film thermo-optic filter chip and a high-speed InGaAs PIN (or APD ("Avalanche PhotoDiode")) photodiode has been recently proposed. The tunable thin-film thermo-optic filter is composed of amorphous silicon and silicon nitride layers and is tuned by applying a current to an associated integrated heater film. The high-speed InGaAs photodiode (PIN or APD) receives the filtered signal wavelength. The avalanche multiplication gain provided by this high-speed InGaAs avalanche photodidode (APD) improves the signal to noise ratio (typically up to 10 dB of receiver sensitivity improvement compared to a classical PIN detector). However, due to low ionization coefficient ratio of the presently used III-V avalanche materials (such as InP, InAlAs and InGaAsP) inducing the avalanche multiplication, a limited (gain x bandwidth) is observed in the high-speed InGaAs photodiode, which limits the bit rate / speed ratio of the tunable receiver and therefore restrains its use to 10 Gb/s applications.

### Summary

So an object of this invention is to improve the situation.

In an embodiment, a photonic tunable receiver is intended for receiving input optical signals with at least two different wavelengths transmitted by an optical fibre, and comprises:
- a photonic chip defining a waveguide,
- a gain chip region bonded to this photonic chip and arranged for amplifying the input optical signals,
- a tunable filter, at least partially integrated into the photonic chip, and arranged for selecting a signal having a desired wavelength amongst the amplified input optical signals, and
- a high speed photodetector bound to the photonic chip and arranged for detecting the selected signal.

This monolithic integration allows the photonic tunable receiver to be more compact and cheaper.

The photonic tunable receiver may include additional characteristics considered separately or combined, and notably:
- it may further comprise a fibre coupler integrated into the photonic chip, and arranged for being coupled to the optical fibre;
- the fibre coupler may be either a vertical grating structure integrated into the photonic chip and arranged for being vertically coupled to the optical fibre, or a spot size converter integrated into the photonic chip and arranged for being laterally coupled to the optical fibre;
- its photonic chip may be a silicon photonic chip defining a silicon waveguide. In this case, its gain chip region may be made of III-V semiconductor materials;
- its high speed photodetector may comprise an absorbing layer made of germanium or InGaAs;
- its tunable filter may comprise at least one thermally tuned ring resonator;
- its tunable filter may comprise at least two cascade thermally tuned ring resonators;
- each thermally tuned ring resonator may comprise a resistor integrated into its photonic chip, and a conductive layer bonded to its photonic chip above this integrated resistor and intended for being fed with a current arranged for inducing a thermal activity of this integrated resistor;
- its tunable filter may be arranged for filtering spontaneous emission noise that is generated by its gain chip region.

### Brief Description of the Figure

Some embodiments of a photonic tunable receiver in accordance with an embodiment of the present invention are now described, by way of example only, and with reference to the accompanying drawings, in which:
- Figure 1 schematically illustrates, in a top view, an example of embodiment of a photonic tunable receiver according to the invention, and
- Figure 2 schematically illustrates, in a cross section view, the photonic tunable receiver illustrated in Figure 1.

### Description of Embodiments

Hereafter is notably disclosed a photonic tunable receiver 1 intended for being coupled to an optical fibre arranged for transmitting optical signals with at least two different wavelengths λₙ (with n = 1 to N). For instance, N = 4 (for 40 Gb/s applications) or 8 (N=2ⁿ with n ≥ 2).

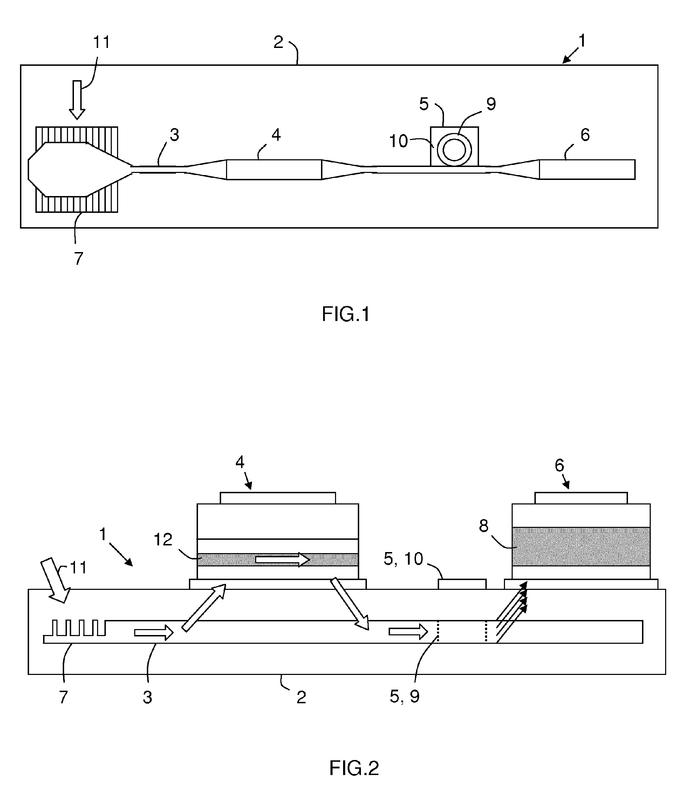

An example of a photonic tunable receiver 1 according to an embodiment of the invention is schematically illustrated in Figures 1 and 2. As illustrated in this non-limiting example, such a photonic tunable receiver 1 comprises at least a photonic chip 2, a gain chip region 4, a tunable filter 5, and a high speed photodetector 6.

The photonic chip 2 defines a waveguide 3 that is arranged for guiding input optical signals 11 provided by an optical fibre.

For instance, the photonic chip 2 may be a silicon photonic chip defining a silicon waveguide 3.

Preferably, the (photonic tunable) receiver 1 comprises also a fibre coupler 7 integrated into the photonic chip 2, connected to the input of the part of the waveguide 3 in which the input optical signals are guided, and arranged for being coupled to the optical fibre.

This fibre coupler 7 is a passive structure that allows improving the coupling efficiency between the waveguide 3 and the optical fibre.

As illustrated in Figures 1 and 2, this fibre coupler 7 may be a vertical grating structure integrated into the photonic chip 2. Such a vertical grating structure is preferably used in the case of vertical coupling with the optical fibre.

In a variant of embodiment, the fibre coupler 7 may be a spot size converter integrated into the photonic chip 2. Such a spot size converter is preferably used in the case of lateral coupling with the optical fibre.

The gain chip region 4 is bonded to the photonic chip 2 and arranged for amplifying the input optical signals that are guided by the waveguide 3. This amplification of the input optical signals aims at preamplifying the optical signals before their injection in the tunable filter 5 and the photodiode 6, in order to increase the receiver sensitivity.

It is recalled that any 3 dB-increase of sensitivity allows an optical fibre access network to double the number of connected customers to a single OLT ("Optical Line Termination").

For instance, this gain chip region 4 may be thermally bonded on the photonic chip 2.

This gain chip region 4 is a vertical multilayer structure comprising a layer 12 in which the optical signals (guided by the waveguide 3) are transferred and then amplified before being re-transferred into the waveguide 3.

When the photonic chip 2 is a silicon photonic chip, the gain chip region 4 is preferably made of III-V semiconductor materials. In this case it constitutes a semiconductor optical amplifier (or SOA). A typical vertical layer structure of an SOA contains an active region made of bulk semiconductor or Multiple Quantum Wells (or MQW) with appropriate band-gap energy for amplification in a given wavelength range (for instance InGaAlAs MQW or InGaAsP/InGaAs MQW). This active region is embedded in two P- and N- SCH layers ("Separate Confinement Heterostructures").

The tunable filter 5 is at least partially integrated into the photonic chip 2 and arranged for selecting a signal having a desired wavelength amongst the input optical signals that have been amplified by the gain chip region 4.

Preferably, this tunable filter 5 acts also as noise filter of the spontaneous emission that is generated by the gain chip region 4.

As illustrated in Figure 1, this tunable filter 5 may comprise at least one thermally tuned ring resonator 9. A cascade of at least two thermally ring resonators 9 can be used to achieve the desirable tuning range.

Also as illustrated in Figures 1 and 2, each thermally tuned ring resonator 5 may comprise a resistor 9 that is integrated into the photonic chip 2, and a conductive layer 10 that is bonded to the photonic chip 2 above the integrated resistor 9 and intended for being fed with a current that is arranged for inducing a thermal activity of the associated integrated resistor 9. The integrated resistor 9 is defined on top of the ring resonator 5. The induced thermal activity of the integrated resistor 9 varies with the intensity of the current that feeds its associated conductive layer 10, and each induced thermal activity allows to select an amplified optical signal with a chosen wavelength. The resonance wavelength of the ring resonator 5 is directly linked to the perimeter of the ring and depends on the geometry of the waveguide. As the refractive index of the waveguide material changes with temperature, the filter wavelength can be adjusted by free carrier injection using metal thin film resistor.

The high speed photodetector 6 is a vertical photodiode multilayer structure bound (for instance by molecular bonding (such as III-V wafer bonding) or direct epitaxy growth (or direct epi-grown for instance of III-V or Ge stacks)) to the photonic chip 2 and arranged for detecting the signal that has been selected by the tunable filter 5. For instance, this photodiode multilayer structure may be grown on the top of the photonic chip 2 above the waveguide 3.

For instance, this high speed photodetector 6 may comprise an absorbing layer 8 made of germanium (or Ge) or InGaAs. Germanium is an absorbing material that is well adapted to detection of optical telecom signals (and notably WDM ("Wavelength Division Multiplexing") channels).

As the bandwidth is only limited by transit time and RC cut-off, this photonic tunable receiver 1 is compatible with very high speed operation (typically 40 Gb/s and beyond).

So, the invention provides a monolithically integrated photonic tunable receiver offering high selection speed, high sensitivity, high compactness and low cost production. Therefore, it may be used in a lot of applications, and notably in TWDM PON systems ("Time and Wavelength Division Multiplexing Passive Optical Network").

It should be appreciated by those skilled in the art that any block diagram herein represent conceptual views of illustrative circuitry embodying the principles of the invention.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Photonic tunable receiver (1) for receiving input optical signals with at least two different wavelengths transmitted by an optical fibre, said photonic tunable receiver (1) comprising i) a photonic chip (2) defining a waveguide (3), ii) a gain chip region (4) bonded to said photonic chip (2) and arranged for amplifying said input optical signals, iii) a tunable filter (5), at least partially integrated into said photonic chip (2), and arranged for selecting a signal having a desired wavelength amongst said amplified input optical signals, and iv) a high speed photodetector (6) bound to said photonic chip (2) and arranged for detecting said selected signal.

2. Photonic tunable receiver according to claim 1, wherein it further comprises a fibre coupler (7) integrated into said photonic chip (2), and arranged for being coupled to said optical fibre.

3. Photonic tunable receiver according to claim 2, wherein said fibre coupler (7) is a vertical grating structure integrated into said photonic chip (2) and arranged for being vertically coupled to said optical fibre.

4. Photonic tunable receiver according to claim 2, wherein said fibre coupler (7) is a spot size converter integrated into said photonic chip (2) and arranged for being laterally coupled to said optical fibre.

5. Photonic tunable receiver according to one of claims 1 to 4, wherein said photonic chip (2) is a silicon photonic chip defining a silicon waveguide (3), and said gain chip region (4) is made of III-V semiconductor materials.

6. Photonic tunable receiver according to claim 5, wherein said high speed photodetector (6) comprises an absorbing layer (8) made of germanium or InGaAs.

7. Photonic tunable receiver according to one of claims 1 to 6, wherein said tunable filter (5) comprises at least one thermally tuned ring resonator.

8. Photonic tunable receiver according to claim 7, wherein said tunable filter (5) comprises at least two cascade thermally tuned ring resonators.

9. Photonic tunable receiver according to one of claims 7 and 8, wherein each thermally tuned ring resonator (5) comprises a resistor (9) integrated into said photonic chip (2), and a conductive layer (10) bonded to said photonic chip (2) above said integrated resistor (9) and intended for being fed with a current arranged for inducing a thermal activity of said integrated resistor (9).

10. Photonic tunable receiver according to one of claims 1 to 9, wherein said tunable filter (5) is arranged for filtering spontaneous emission noise that is generated by said gain chip region (4).
